Europäisches Patentamt

European Patent Office

Office européen des brevets

(11) Publication number: **0 207 672**
**A1**

# EUROPEAN PATENT APPLICATION

(21) Application number: 86304598.5

(22) Date of filing: 16.06.86

(51) Int. Cl.⁴: **H03K 17/56** , H03K 17/04

(30) Priority: 17.06.85 JP 131296/85

(43) Date of publication of application:
07.01.87 Bulletin 87/02

(84) Designated Contracting States:
DE FR GB

(71) Applicant: FUJI ELECTRIC CO., LTD.
1-1, Tanabeshinden, Kawasaki-ku
Kawasaki-shi Kanagawa 210(JP)

(72) Inventor: Shigekane, Hisao
B-406, Yokota 180-10
Matsumoto-shi Nagano 390(JP)

(74) Representative: Gordon, Martin et al
G.F. Redfern & Company Marlborough Lodge
14 Farncombe Road
Worthing West Sussex, BN11 2BT(GB)

(54) Switching device.

(57) A composite transistor comprising a cascade arrangement of a bipolar transistor (Q1) and field effect transistor (Q2) serves to control supply of a load current ($I_c$). In order to ameliorate problems due to stray inductance a third transistor (Q3) provides a shunt path for the base current ($I_{B1}$) and accumulated base carrier charge from the base (B1) of the bipolar transistor (Q1) to source (S) of the field effect transistor (Q), the third transistor (Q3) being switched ON in response to signal $e_G$ when the latter causes field effect transistor the (Q2) to be switched OFF. The third transistor (Q3) may be controlled via a fourth transistor in response to the signal $e_G$.

Fig. 1 (A)

EP 0 207 672 A1

## SWITCHING DEVICE

This invention relates to a switching device comprising two transistors, that is, a first bipolar transistor and a second field effect or bipolar transistor.

In the following description and in the drawings, identical reference numerals are used in relation to identical or corresponding components. Binary digital levels "high", "low" are indicated only by "H" and "L".

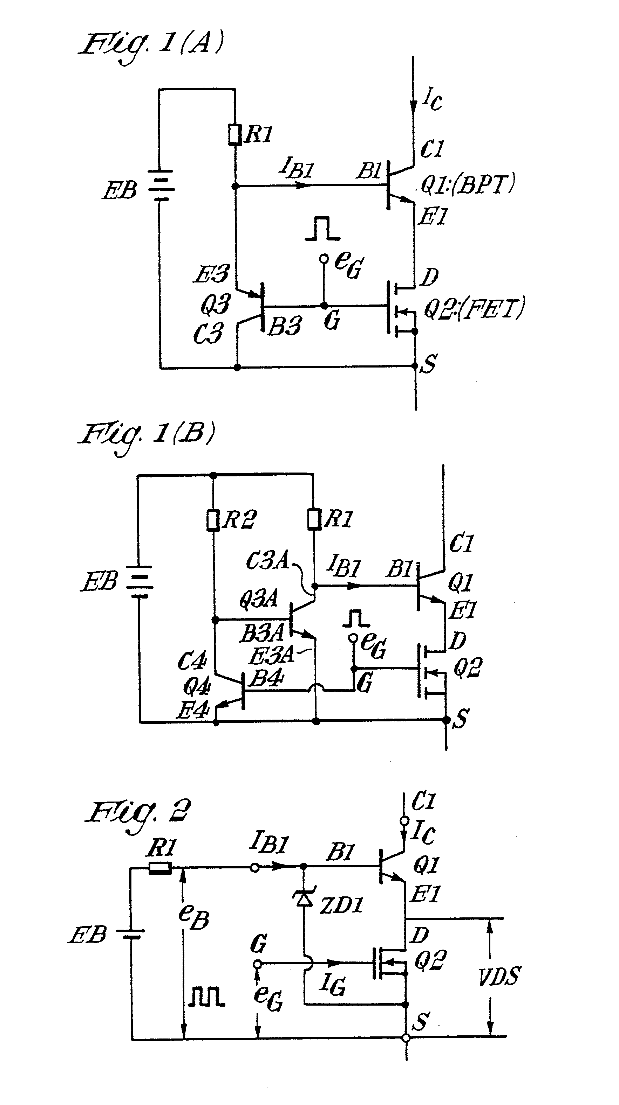

A prior art arrangement and problems associated with it will now be described with reference to Fig. 2 in which is shown one embodiment of a circuit comprising two transistors in a so-called cascade arrangement.

Referring to Fig. 2, a main bipolar transistor Q1 (hereinafter referred to as a BPT), a field effect transistor Q2 (hereinafter referred to as an FET) and a zener diode ZD1 are interconnected as shown in an arangement referred to herein as a composite transistor.

The collector G1 and the emitter E1 of the BPT Q1, and the drain D and the source S of the FET Q2 are connected in series at the emitter E and the drain D to enable current supplied to a load (not shown) to be switched ON-OFF (for the sake of convenience, this current is reffered to herein as the collector current). Further, the transistors Q1 and Q2 are collectively referred to as a composite transistor for the sake of the convenience. The zener diode ZD1 is connected between the base B1 of the BPT Q1 and the source S of the FET Q2 in such a way that the side of the base B1 comprises the cathode side of the diode.

An ON-OFF signal voltage $e_G$, determining the ON-OFF state of the collector current $I_c$, is applied by way of a driving circuit (not shown) between the gate G and the source S of the FET Q2, while a base current $I_{B1}$ is supplied to the base B1 via a base power source EB connected between the base B1 of the BPT Q1 and the source S of the FET Q2 when the latter is turned ON.

The circuit is arranged to provide a composite switching element at high speed and high voltage endurance by the combination of high speed and low voltage endurance characteristics of the FET Q2 and low speed and high endurance bipolar characteristics of the transistor Q1 taking notice of the fact that the switching speed of an FET is generally greater than that of a bipolar transistor.

Referring first to the case of turning the composite transistor Q1 and Q2 ON, since the FET Q2 is connected to the emitter E1 of the BPT Q1 to enable the base current $I_{B1}$ to be turned ON and OFF in this circuit, and the base voltage $e_B$ applied to the base B1 of the BPT Q1 can be made relatively high, when the ON-OFF signal voltage $e_G$ is applied (with signal level "H" here) to the FET Q2 to turn the transistor Q2 ON, the voltage VDS between the drain D and the source S falls rapidly thereby abruptly raising the base current $I_{B1}$ to rapidly turn BPT Q1 ON and, accordingly, both transistors Q1, Q2 are switched ON. In this case, the zener diode ZD1 is in the OFF state (nonconduction).

When turning OFF the composite transistor Q1 and Q2, an ON-OFF signal voltage $e_G$ is applied - (with signal level "L" here) to the FET Q2 to turn OFF the transistor Q2. The voltage VDS between the drain D and the source S of the FET Q2 abruptly increases to block the collector current $I_c$. At this instant, the collector current $I_c$ flowing through the base and the emitter of the BPT Q1 is transferred to the zener diode ZD1. In this way, since carriers accumulated at the base of the BPT Q1 are rapidly discharged, the transistor Q1 and, accordingly, the composite transistor Q1 and Q2, is rapidly turned OFF to interrupt the collector current $I_c$.

In this case, the zener diode ZD1 is used in the transferring path as described above, so as to maintain the voltage VDS between the drain and the source of the FET Q2 to lower than a limit voltage capable of turning off (switching inhibition voltage BVDS) upon turning OFF the FET Q2, that is, upon transfer of the collector current $I_c$, while hindering wasteful shunting, via the zener diode, of the base current $I_{B1}$ supplied from the base power supply EB to the connection to the base B1 of the BPT Q1, in the case where the composite transistor Q1 and Q2 is turned ON, so that it effectively forms the base current $I_B$.

However, the device shown in Fig. 2 has the disadvantage that when the FET Q2 turns OFF and the accumulated base carriers of the BPT Q1 discharge through the zener diode ZD1, the latter generates considerable heat because it has a high threshold voltage and therefore an expensive element which is resistive to such heat must be used as the zener diode ZD1.

It is an object of the present invention to provide a switching device which ameliorates such problems and reduces heat losses in an economical manner.

According to this invention there is provided a switching device comprising a first bipolar transistor having its collector-emitter main conductive path connected in series with the main conductive path of a second transistor having a control electrode for receiving an ON-OFF control signal voltage for switching ON and OFF the second transistor so as to open and close the series-connected main conductive paths for controlling the supply of a load current, connections being provided for supplying base current to the first transistor, a third transistor having its main conductive path connected across said base current supply connections, said third transistor having its control electrode arranged to receive a signal synchronised with said ON-OFF control signal voltage such that when said second transistor is turned ON, said third transistor is turned OFF and when said second transistor is turned OFF, said third transistor is turned ON.

Embodiments of the present invention will now be described, by way of example, with reference to the accompanying drawings in which:-

Figs. 1(A) and (B) are respective circuit diagrams of different forms of switching device embodying the present invention; and

Fig. 2 is a circuit diagram of a known form of switching device.

In Fig. 1(A) there is shown a modified form of the switching device shown in Fig. 2 in which a PNP type auxiliary transistor Q3 is provided instead of the zener diode ZD1. The emitter E3 of the transistor Q3 is connected to the base of the BPT Q1 and the base B3 is connected to the gate G of the FET Q2. The base B3 of the auxiliary transistor Q3 is thus driven, together with the gate G of FET Q2, by the common ON-OFF signal $e_G$.

In this circuit, when the ON-OFF signal $e_G$ is "H", FET Q2 is ON and the auxiliary transistor Q3 turns OFF because the base-emitter voltage BE becomes 0 or is reverse-biased. As a result, a base current $I_{B1}$ is supplied to the BPT Q1 and the composite transistor Q1, Q2 quickly switches ON. However, in this case, it is assumed that the "H" level of signal voltage $e_G$ is equal at least to the voltage of the base power supply EB.

When the signal voltage $e_G$ becomes "L", the FET Q2 turns OFF, the auxiliary transistor Q3 turns ON, and the base current $I_{B1}$ is shunted through the emitter-collector path E3C3 of the auxiliary transistor Q3. Simultaneously, accumulated base carriers of the BPT Q1 discharge through said emitter-collector path and the composite transistor Q1, Q2 quickly turns OFF.

In this case, a collector-emitter voltage VCD - (sat) when the auxiliary transistor (Q3) is ON is lower than the threshold voltage of said zener diode ZD1 and heat losses are thereby reduced.

In Fig. 1(B) there is shown a modified form of the device shown in Fig. 2 where the same effect can be obtained by utilizing two NPN auxiliary transistors Q3A, Q4 in place of the single PNP auxiliary transistor Q3. In this case, the collector C3A and emitter E3A of the transistor Q3A are respectively connected to the base B1 of the BPT Q1 and the Source S of the FET Q2.

In this circuit, when the ON-OFF signal voltage $e_G$ is "H" (i.e. the composite transistor Q1, Q2 is ON), the auxiliary transistor Q4 is ON and therefore the base B3A and emitter E3A of the auxiliary transistor Q3A are short-circuited and the transistor Q3A is OFF. Accordingly, a base current $I_{B1}$ is supplied to the BPT Q1. Meanwhile, when the signal voltage $e_G$ is "L" (i.e. the composite transistor Q1, Q2 is OFF), the auxiliary transistor Q4 is OFF and the auxiliary transistor Q3A is ON because a base current is supplied to the base thereof from the base power supply EB through resistor R2. As a result, a shunt path is provided between the base B1 and source S of the composite transistor Q1, Q2. Thus, the two auxiliary transistors Q3A, Q4 operate in the same way as the one auxiliary transistor Q3 in the device shown in Fig. 1(A).

In modified forms of the embodiment, the same operation is carried out even when the FET Q2 is a bipolar transistor and the auxiliary transistors Q3, Q3A are field effect transistors.

The emboximents shown in Figs. 1(A) and 1-(B) provide the following advantages over the device shown in Fig. 2:-

1. The large switching loss generated in the zener diode of the device shown in Fig. 2 is reduced in the embodiments shown in Figs. 1(A) and 1(B).

2. Since the base voltage of the BPT Q1 is smaller than the threshold voltage of the zener diode when the BPT Q1 is OFF, a fast switching speed of the composite transistor can be realised.

The embodiments described above provide a switching device comprising a first bipolar transistor Q1 having its collector-emitter main conductive path C1E1 connected in series with the main conductive path DS of a second transistor Q2 having a control electrode G for receiving an ON-OFF control signal voltage $e_G$ for switching ON and OFF the second transistor Q2 so as to open and close the series-connected main conductive paths C1E1,DS for controlling the supply of a load current $I_c$, connections being provided for supplying base current $I_{B1}$ to the first transistor Q1, a third transistor Q3, Q3A having its main conductive path connected across said base current supply connections, said third transistor Q3, Q3A having its control electrode arranged to receive a signal synchronised with said ON-OFF control signal voltage $e_G$ such that when said second transistor Q2 is turned ON, said third transistor Q3, Q3A is turned OFF and when said second transistor Q2 is turned OFF, said third transistor Q3, Q3A is turned ON.

## Claims

1. A switching device comprising a first bipolar transistor having its collector-emitter main conductive path connected in series with the main conductive path of a second transistor having a control electrode for receiving an ON-OFF control signal voltage for switching ON and OFF the second transistor so as to open and close the series-connected main conductive paths for controlling the supply of a load current, connections being provided for supplying base current to the first transistor, a third transistor having its main conductive path connected across said base current supply connections, said third transistor having its control electrode arranged to receive a signal synchronised with said ON-OFF control signal voltage such that when said second transistor is turned ON, said third transistor is turned OFF and when said second transistor is turned OFF, said third transistor is turned ON.

2. A switching device arranged to supply a base current to a first transistor by connecting the emitter of the first transistor to the drain (collector) of a second transistor and connecting an auxiliary DC power supply between the base of the first transistor and the source (emitter) of the second transistor and to apply an ON-OFF signal voltage between the gate (base) and the source (emitter) of the second transistor so as to turn ON and OFF a load current to be supplied to an external circuit through a series arrangement of the collector-emitter path of the first transistor and the drain-source - (collector-emitter) path of the second transistor, the collector-emitter (drain-source) path of a third transistor being connected between the base of the first transistor and the source (emitter) of the second transistor such as to be capable of shunting the base current of the first transistor, the base - (gate) of the third transistor being arranged to be driven with a signal voltage synchronised with said ON-OFF signal voltage so that the third transistor is turned OFF when the second transistor is turned ON, while the third transistor is turned ON when the second transistor is turned OFF.

3. A switching device according to claim 1, wherein said second and/or third transistor is a field effect transistor whose drain-source path provides said main conductive path.

4. A switching device according to claim 1, wherein said second and/or third transistor is a bipolar transistor whose collector-emitter path provides said main conductive path.

5. A switching device according to claim 1, wherein said second transistor is a field effect transistor and said third transistor is a bipolar transistor.

6. A switching device according to any one of the preceding claims wherein said second and third transistors have a common control electrode connection for receiving said ON-OFF control signal voltage.

7. A switching device according to any one of claims 1 to 5 wherein a fourth transistor has its control electrode connected in common with the control electrode of the second transistors, the main conductive path of said fourth transistor being arranged to determine a signal voltage supplied to the control electrode of the third transistor in synchronism with said ON-OFF control signal voltage received by the control electrodes of the second and fourth transistors.

*Fig. 1(A)*

*Fig. 1(B)*

*Fig. 2*

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| Y | DE-A-3 338 627  (LICENTIA PATENT-VERWALTUNGS-GMBH) <br> * figure 1, elements 2, 3, 14; abstract; claim 1; page 3, line 15 - page 4, line 18; page 5, line 19-page 7, line 7 * | 1-5 | H 03 K  17/56 <br> H 03 K  17/04 |
| | --- | | |
| Y | GB-A-2 053 606  (GOULD ADVANCE LTD.) <br> * figure 3, elements 32, 33, 41; abstract; page 2, lines 63-64 * | 1-5 | |
| | --- | | |
| A | EP-A-0 108 283  (SIEMENS AG) <br> * figures 1, 2; abstract * | 1,2 | |
| | --- | | |
| P,A | US-A-4 547 686  (D.Y. CHEN) <br> * figure 1; abstract * | 1,2 | |
| | --- | | DOMAINES TECHNIQUES RECHERCHES (Int. Cl.4) |
| A | ELECTRONIQUE APPLICATIONS, no. 31, pages 35-44, August-September 1983, Evry, France; "Darlington, Bipmos, Cascode: caractéristiques et critères d'emploi" <br> * figure 8b * | 1,2 | H 03 K  17/04 <br> H 03 K  17/08 <br> H 03 K  17/10 <br> H 03 K  17/56 <br> H 03 K  17/60 |
| | ---                    -/- | | |

Le présent rapport de recherche a été établi pour toutes les revendications

| Lieu de la recherche <br> BERLIN | Date d'achèvement de la recherche <br> 21-08-1986 | Examinateur <br> ARENDT M |
|---|---|---|

## DOCUMENTS CONSIDERES COMME PERTINENTS

Page  2

| Catégorie | Citation du document avec indication, en cas de besoin, des parties pertinentes | Revendication concernée | CLASSEMENT DE LA DEMANDE (Int. Cl.4) |
|---|---|---|---|
| A | ELEKTRIE, vol. 37, no. 10, 1983, pages 515-519, Berlin, DDR; H. CONRAD: "Neue leistungselektronische Bauelemente aus applikativer Sicht"<br>* figures 7, 10 *<br><br>----- | 1,2 | |

DOMAINES TECHNIQUES
RECHERCHES (Int. Cl.4)

Le present rapport de recherche a été établi pour toutes les revendications

| Lieu de la recherche<br>BERLIN | Date d'achèvement de la recherche<br>21-08-1986 | Examinateur<br>ARENDT M |
|---|---|---|

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

OEB Form 1503 03 82